Europäisches Patentamt

European Patent Office

Office européen des brevets

(11) Numéro de publication: **0 293 954**
**A1**

## (12) DEMANDE DE BREVET EUROPEEN

(21) Numéro de dépôt: **88200816.2**

(22) Date de dépôt: **27.04.88**

(51) Int. Cl.⁴: **H01L 21/56 , B29C 45/34**

(30) Priorité: **06.05.87 FR 8706395**

(43) Date de publication de la demande:
**07.12.88 Bulletin 88/49**

(84) Etats contractants désignés:
**DE FR GB IT**

(71) Demandeur: **RTC-COMPELEC**
**117, quai du Président Roosevelt**
**F-92130 Issy les Moulineaux(FR)**

(84) **FR**

(71) Demandeur: **N.V. Philips'**
**Gloeilampenfabrieken**
**Groenewoudseweg 1**
**NL-5621 BA Eindhoven(NL)**

(84) **DE GB IT**

(72) Inventeur: **Pellerin, Lucien**
**SOCIETE CIVILE S.P.I.D. 209, rue de**
**l'Université**
**F-75007 Paris(FR)**
Inventeur: **Nijboer,Sjoerd**
**SOCIETE CIVILE S.P.I.D. 209, rue de**
**l'Université**
**F-75007 Paris(FR)**

(74) Mandataire: **Pinchon, Pierre et al**
**Société Civile S.P.I.D. 209 rue de l'Université**
**F-75007 Paris(FR)**

(54) Procédé et moule pour l'encapsulation d'un dispositif semiconducteur par injection de résine.

(57) - Procédé d'encapsulation d'un dispositif semi-conducteur (17) muni de conducteurs métalliques (18), par injection de résine dans une cavité de moulage (20) surmontant ce dispositif.

- Préalablement à l'injection et durant une portion substantielle de cette opération, on soumet la cavité de moulage et le canal d'injection (21) conduisant à cette cavité à une évacuation d'air pratiquée au moyen d'une conduite de vide (30) débouchant dans la cavité au travers d'une paroi poreuse (33).

- De préférence l'injection est réalisée par un seuil (36) situé entre deux conducteurs métalliques adjacents.

- Encapsulation des dispositifs semiconducteurs.

FIG.1

## PROCEDE ET MOULE POUR L'ENCAPSULATION D'UN DISPOSITIF SEMI-CONDUCTEUR PAR INJECTION DE RESINE.

La présente invention concerne un procédé d'encapsulation d'un dispositif semiconducteur muni de conducteurs métalliques auxquels il est électriquement relié, par injection d'une résine dans une cavité de moulage surmontant ledit dispositif tandis qu'une portion terminale des conducteurs métalliques émerge à l'extérieur de la cavité de moulage. L'invention concerne également un moule pour la mise en oeuvre de ce procédé. Ainsi défini, un tel procédé est notamment connu du brevet US-A-3 716 764.

Parmi tous les procédés d'encapsulation de dispositifs semiconducteurs le procédé d'injection sous pression est un de ceux qui se prêtent le mieux à une mécanisation poussée et à une fabrication en grandes quantités de pièces, de manière reproductible.

En général, dans un stade final de la fabrication, les dispositifs semiconducteurs sont électriquement connectés à des conducteurs provisoirement reliés entre eux sous forme de bandes à positions multiples après quoi l'enrobage par une résine peut être opéré de manière collective au moyen d'un moule possédant des cavités multiples disposées en correspondance avec le pas des dispositifs et déterminant la forme des boîtiers. Après quoi, les dispositifs sont séparés les uns des autres en sectionnant les barrettes métalliques de maintien.

Une attention particulière doit être apportée sur le choix des plans de joint du moule de manière à ce que la marque inévitable de ce joint soit située à un emplacement du boîtier qui soit le moins gênant possible.

Dans le cas particulier des dispositifs émetteurs de lumière, les exigences de la qualité de la surface externe des boîtiers sont élevées notamment du côté du boîtier par où la lumière est émise vers l'extérieur et où le dôme de matière transparente d'enrobage doit respecter rigoureusement une forme caractéristique.

Un plan de joint notamment ne serait pas admissible dans cette zone du boîtier car il perturberait le faisceau de lumière émis et donnerait un aspect inhomogène et inesthétique au dispositif en fonctionnement.

Dans le procédé de moulage par injection, on cherche donc à éviter d'effectuer un plan de joint dans le corps du boîtier, corps qui viendrait alors d'une partie unique du moule tandis que le plan de joint, nécessaire pour le dégagement de la pièce terminée, serait placé uniquement à la base du boîtier, c'est-à-dire sur la surface externe de la matière d'enrobage qui est traversée par les conducteurs métalliques. Dans cette solution, on se heurte cependant à la difficulté que l'air contenu dans la cavité de moulage ne peut pas s'échapper suffisamment au moment de l'injection ce qui entraîne un ralentissement de la vitesse de remplissage des cavités et un risque d'inclusion de bulles d'air dans les boîtiers.

Une autre difficulté liée au procédé de moulage par injection provient du fait que les liaisons électriques effectuées sur le corps semiconducteur au moyen de fils de très faible diamètre peuvent être endommagées par le flux de matière d'enrobage injecté sous forte pression dans la cavité de moulage.

Les paramètres de température de la résine, sa viscosité, la pression d'injection qui déterminent ensemble la vitesse de remplissage par comparaison avec la vitesse de refroidissement de cette résine au contact du moule maintenu à température inférieure, sont à cet égard très critiques et apparaissent comme difficilement conciliable pour éviter l'arrachement des fils de liaison lors de l'injection.

Il a donc été proposé d'effectuer un préenrobage du composant semiconducteur et de son fil de connection en vue d'augmenter la tenue mécanique de ce fil et de diminuer ainsi le risque d'arrachement du fil pendant l'injection. Il serait cependant souhaitable, notamment pour un point de vue du prix, de pouvoir supprimer cette opération supplémentaire.

L'invention vise à fournir un perfectionnement au procédé d'encapsulation par injection avec lequel les inconvénients cités précédemment sont éliminés au moins dans une large mesure, qui permet une augmentation sensible de la vitesse d'injection et permet d'obtenir des dispositifs terminés de très bonne qualité même lorsqu'on opère sur des dispositifs sans préenrobage.

Conformément à l'invention ce but est atteint par un procédé d'encapsulation d'un dispositif semiconducteur par injection de résine caractérisé en ce que préalablement à l'injection de la résine on soumet la cavité de moulage et le canal d'injection conduisant à cette cavité à une évacuation de l'air qu'ils contiennent au moyen d'une conduite de vide débouchant dans la cavité de moulage au travers d'une paroi poreuse aux gaz, et en ce que cette évacuation est poursuivie au moins pendant une partie substantielle de l'opération d'injection de la résine dans la cavité de moulage.

Du fait que l'air contenu dans les cavités de moulage et les canaux d'injection est évacué, le flux de résine liquide n'est pas freiné par une contre-pression et l'opération de remplissage s'effectue plus rapidement. Ceci offre de multiple avantages : la résine est moins sujette à l'oxydation et aux brûlures par compression pendant son trajet jusqu'aux cavités, le risque d'inclusion de bulles d'air est éliminé et la pression d'injection peut être réduite d'environ 25% par rapport à celle qui est nécessaire en l'absence d'évacuation. On a constaté qu'en utilisant une telle pression réduite, le risque de détérioration des liaisons électriques était pratiquement éliminé.

La particularité consistant à pratiquer l'évacuation au moyen d'une conduite intérieure au moule débouchant dans les cavités au travers d'une paroi poreuse aux gaz permet d'obtenir cette évacuation de l'air en un temps très bref compte tenu du faible volume à évacuer et permet aussi de poursuivre l'évacuation pendant la phase d'injection ce qui s'oppose à toute remontée de pression d'air résultant de fuites par les joints du moule.

L'invention concerne également un moule pour la mise en oeuvre du procédé précédemment défini, caractérisé en ce que le seuil d'injection débouche dans la cavité de moulage dans une position adjacente à la paroi poreuse et en ce que la direction du flux d'injection est sensiblement perpendiculaire à la surface de la paroi poreuse qui borde ladite cavité.

Selon cette disposition avantageuse, le flux de matière d'enrobage se dirige tout d'abord du côté de la cavité qui est opposé à la surface de la paroi poreuse et le remplissage de la cavité se termine du côté qui est au voisinage de cette paroi, ce qui a pour effet de fournir une pleine efficacité à l'évacuation pratiquée dans la cavité durant toute la phase d'injection de la matière d'enrobage.

Selon un mode particulier de mise en oeuvre de l'invention particulièrement adapté à la fabrication de diodes électroluminescentes, la surface de la paroi poreuse qui borde la cavité est située dans le plan par lequel la portion terminale des conducteurs métalliques émerge, et en ce que le seuil d'injection débouche dans ce plan entre deux conducteurs métalliques. De cette manière les petites perturbations de surface du boîtier résultant du moulage par contact avec la paroi poreuse, celles du plan de joint et du seuil d'injection sont toutes réunies dans la même région, à la base du boîtier, là où ces perturbations sont les moins gênantes.

La description qui va suivre en regard des dessins annexés donnés à titre d'exemples non limitatifs, fera bien comprendre comment l'invention peut être réalisée.

La figure 1 représente une vue schématique en coupe d'un moule pour la mise en oeuvre du procédé selon l'invention et

la figure 2 donne une vue en plan limitée à un détail de la partie centrale du moule de la figure 1.

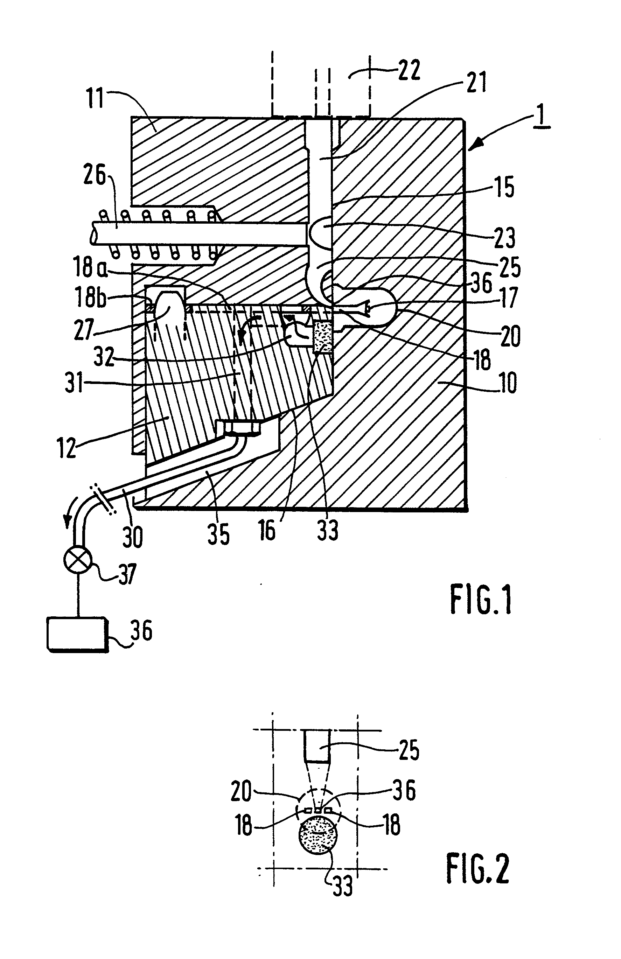

La figure 1 montre un exemple de moule 1 utilisant le procédé selon l'invention dans une application à l'encapsulation d'un dispositif semiconducteur qui est ici une diode électroluminescente.

Le moule 1 se compose d'une partie fixe 10, d'une partie mobile 11 et d'un tiroir 12. Pour plus de simplicité, le système d'articulation habituelle qui retient le tiroir 12 lors de l'ouverture du moule 1 n'a pas été représentée sur la figure, de même que les moyens nécessaires à la fermeture de ce moule qui appartiennent au domaine connu de la technique de moulage. Le plan principal de fermeture du moule ou plan de joint principal est indiqué par le repère 15 et se prolonge le long du tiroir 12 par un plan de joint annexe 16 dont l'inclinaison permet un bon maintien du tiroir 12 lorsque le moule 1 est en position de fermeture.

Un dispositif semiconducteur, à encapsuler, a été représenté à l'intérieur du moule, il comporte le cristal semiconducteur 17 raccordé électriquement à des conducteurs métalliques 18 dont une portion terminale 18a émerge à l'extérieur du boîtier à réaliser par injection. La partie active du dispositif semiconducteur 17, 18 est surmontée par une cavité de moulage 20 qui va être remplie de résine injectée au moyen d'un canal d'injection 21 réalisé dans la partie mobile 11 du moule, au voisinage du plan de joint principal 15. Ce canal d'injection 21 est en liaison avec le nez 22 de la machine d'injection représenté schématiquement en tirets, qui est appuyé fermement contre le moule 1. Le moule 1 comporte une pluralité de positions de moulage disposées linéairement dans une direction qui est perpendiculaire au plan de coupe de la figure 1. Pour assurer l'alimentation en résine des différentes cavités de moulage 20, le canal d'injection 21 comporte un canal de répartition 23 s'étendant dans une direction perpendiculaire et qui distribue la matière d'enrobage dans chacune des branches individuelles d'injection 25.

Le moule 1 comporte encore une aiguille d'éjection 26 de la carotte qui est actionnée après moulage lors de l'ouverture et de l'éloignement de la partie mobile 11 du moule, tandis que par ailleurs, le tiroir 12 porte un doigt de positionnement 27 qui coopère avec une ouverture correspondante présentée par une barrette de liaison 18b des conducteurs métalliques du dispositif.

Conformément au procédé selon l'invention, avant de réaliser l'injection et alors que le nez 22 de la machine d'injection est appliqué contre le moule, on soumet les cavités de moulage 20, le canal d'injection 21, son canal de répartition 23 et ses branches individuelles 25 à une évacuation de l'air qu'ils contiennent au moyen d'une conduite de vide 30, 31, 32 qui débouche dans chaque cavité de moulage 20 à travers une paroi poreuse 33.

Cette paroi poreuse 33 est réalisée par exemple en métal fritté qui est choisi suffisamment poreux pour pouvoir obtenir une bonne évacuation en un temps court, de quelques secondes, mais qui forme une barrière à l'écoulement de la résine lors de l'injection. La conduite de vide 31, 32 est disposée à l'intérieur du tiroir 12 selon une technique qui s'apparente à celle d'un canal d'injection, tandis qu'a l'extérieur du tiroir, une tubulure 30 pour le vide chemine dans une gorge 35 pratiquée dans la partie fixe 10 du moule, et est raccordée à un système de pompage 36 via une vanne 37 commandée électriquement.

Avantageusement, l'opération d'évacuation de l'air est poursuivie pendant au moins une partie substantielle de l'opération d'injection et de préférence jusqu'à la phase de maintien en pression qui suit le remplissage des cavités de moulage.

Selon un mode préféré de mise en oeuvre de l'invention, représenté sur la figure 1, la surface de la paroi poreuse 33 qui borde la cavité de moulage 20 est située dans le plan de base du boîtier par lequel la portion terminale 18a des conducteurs métalliques émerge du boitier, et la branche individuelle 25 d'alimentation a un seuil d'injection 36 qui débouche dans la cavité de moulage 20 dans une position adjacente à la surface de la paroi poreuse 33. De plus, le seuil d'injection 36 est disposé de telle manière que la direction du flux de la matière injectée dans la cavité est sensiblement perpendiculaire au plan de base du boîtier qui contient la surface de la paroi poreuse 33. Avec une telle disposition, la matière injectée commence par emplir la partie de la cavité qui est à l'opposé du seuil d'injection 36 alors que la fin du remplissage s'effectue au voisinage du plan de joint 15. C'est pourquoi l'évacuation d'air joue un rôle efficace pendant la phase d'injection, les traces d'air résiduel étant éliminées au fur et à mesure du remplissage de la cavité de moulage 20. De plus, les fils de connexion électrique du dispositif semiconducteur ne sont pas directement exposés au flux d'injection.

La figure 2 représente une vue dans le plan de joint 15 qui est limitée à l'emplacement d'une cavité de moulage.

Les éléments correspondants à ceux de la figure 1 y sont affectés des mêmes repères numériques. Comme visible aux figures 1 et 2, et selon un mode de mise en oeuvre avantageux, le seuil d'injection 36 débouche dans la cavité de moulage 20 au niveau du plan de joint 15 entre deux conducteurs métalliques 18 adjacents. De cette manière, les petites perturbations apportées à la surface du boîtier qui sont dues à la technique de moulage par injection sont toutes rassemblées au voisinage du plan de base du boîtier à un endroit où ces imperfections n'offrent pas d'inconvénients notables lors de l'utilisation du dispositif.

Dans le cas décrit de l'encapsulation d'une diode électroluminescente, on utilise une résine thermoplastique transparente comme un polycarbonate, un polyphtalate-carbonate, ou un polyarylate.

Le procédé selon l'invention s'applique non seulement à l'encapsulation de diodes électroluminescentes mais plus généralement à tout dispositif semiconducteur dont le boîtier peut être réalisé par moulage de résine.

## Revendications

1. Procédé d'encapsulation d'un dispositif semiconducteur muni de conducteurs métalliques auxquels il est électriquement relié, par injection d'une résine dans une cavité de moulage surmontant ledit dispositif tandis qu'une portion terminale des conducteurs métalliques émerge à l'extérieur de la cavité de moulage caractérisé en ce que préalablement à l'injection de la résine on soumet la cavité de moulage et le canal d'injection conduisant à cette cavité à une évacuation de l'air qu'ils contiennent au moyen d'une conduite de vide débouchant dans la cavité de moulage au travers d'une paroi poreuse aux gaz, et en ce que cette évacuation est poursuivie au moins pendant une partie substantielle de l'opération d'injection de la résine dans la cavité de moulage.

2. Moule pour la mise en oeuvre du procédé selon la revendication 1 caractérisé en ce que le seuil d'injection débouche dans la cavité de moulage dans une position adjacente à la paroi poreuse et en ce que la direction du flux d'injection est sensiblement perpendiculaire à la surface de la paroi poreuse qui borde ladite cavité.

3. Moule selon la revendication 2 caractérisé en ce que la surface de la paroi poreuse qui borde la cavité est située dans le plan par lequel la portion terminale des conducteurs métalliques émerge, et en ce que le seuil d'injection débouche dans ce plan entre deux conducteurs métalliques adjacents.

FIG.1

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | PATENT ABSTRACTS OF JAPAN, vol. 10, no. 259 (E-434)[2315], 4 septembre 1986, page 117 E 434; & JP-A-61 85 829 (MICHIO OSADA) 01-05-1986 * En entier * | 1 | H 01 L 21/56 B 29 C 45/34 |
| Y | DE-C-3 424 742 (SKF) * Revendication 1 * | 1 | |
| A | PATENT ABSTRACTS OF JAPAN, vol. 10, no. 302 (E-445)[2358], 15 octobre 1986, page 127 E 445; & JP-A-61 117 842 (HITACHI MICRO COMPUT. ENG. LTD) 05-06-1986 | 1 | |
| A | EP-A-0 130 552 (MOTOROLA) | | |
| A | GB-A-1 462 622 (CLEAREX PLASTICS) * Revendication 1 * | 1 | |
| A | GB-A-2 123 334 (COOLMATION) * Revendication 4 * | 1 | DOMAINES TECHNIQUES RECHERCHES (Int. Cl.4) H 01 L B 29 C |

Le présent rapport a été établi pour toutes les revendications

| Lieu de la recherche | Date d'achèvement de la recherche | Examinateur |
|---|---|---|
| LA HAYE | 03-08-1988 | DE RAEVE R.A.L. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
.............................................................................
& : membre de la même famille, document correspondant

EPO FORM 1503 03.82 (P0402)